Europäisches Patentamt

**European Patent Office**

**Office européen des brevets**

(11) Numéro de publication: **0 099 788**
**A1**

# (12) DEMANDE DE BREVET EUROPEEN

(21) Numéro de dépôt: **83401335.1**

(22) Date de dépôt: **28.06.83**

(51) Int. Cl.³: **H 01 G 13/02**

(30) Priorité: **09.07.82 FR 8212111**

(43) Date de publication de la demande:
**01.02.84 Bulletin 84/5**

(84) Etats contractants désignés:
**CH DE GB IT LI**

(71) Demandeur: **L.C.C.-C.I.C.E. - COMPAGNIE
EUROPEENNE DE COMPOSANTS ELECTRONIQUES
101, Boulevard Murat
F-75781 Paris Cedex 16(FR)**

(72) Inventeur: **Guigue, Jean-Marc
THOMSON-CSF SCPI 173, bld Haussmann
F-75379 Paris Cedex 08(FR)**

(74) Mandataire: **Jacquard, Philippe et al,
THOMSON-CSF SCPI 173, Bld Haussmann
F-75379 Paris Cedex 08(FR)**

(54) **Dispositif de mesure de la capacité d'un condensateur au cours de son bobinage.**

(57) La présente invention a pour objet un dispositif de mesure de la capacité d'un condensateur au cours de son bobinage qui met en oeuvre l'enroulement de rubans superposés comportant au moins deux rubans conducteurs correspondant chacun à une électrode du condensateur et dans lequel chacun des rubans conducteurs est relié électriquement à un pont de mesure de capacité. Au moins un des rubans conducteurs (1) est mis en contact électrique avec un rouleau tournant (2) électriquement conducteur. Une brosse (10) présentant une pluralité de fibres conductrices (4) est en contact électrique avec le rouleau tournant (2) et une pièce électriquement conductrice (8, 9) est en contact avec les fibres conductrices et relié électriquement au pont de mesure.

FIG_1

EP 0 099 788 A1

## DISPOSITIF DE MESURE DE LA CAPACITE
## D'UN CONDENSATEUR AU COURS DE SON BOBINAGE

La présente invention a pour objet un dispositif de mesure de la capacité d'un condensateur au cours de son bobinage.

La fabrication de condensateurs bobinés met en oeuvre l'enroulement de rubans superposés comportant au moins deux rubans conducteurs correspondant chacun à une électrode du condensateur. Il est connu du brevet US 3 815 188, une machine de fabrication de condensateurs bobinés mettant en oeuvre un pont capacitif pour mesurer la valeur de la capacité en cours de bobinage. Le contact électrique est établi grâce à des brosses conductrices qui frottent contre des rubans métalliques constituant les armatures du condensateur. La mesure de la capacité est entachée d'erreurs du fait que le contact électrique entre la brosse et le ruban métallique est difficile à obtenir dans de bonnes conditions sans détériorer celui-ci.

La présente invention a pour objet un dispositif de mesure de la capacité d'un condensateur au cours de son bobinage qui ne présente pas les inconvénients précités.

Pour ce faire, il est caractérisé en ce qu'au moins un des rubans conducteurs est mis en contact électrique avec un rouleau tournant électriquement conducteur et en ce qu'il comporte une brosse présentant une pluralité de fibres conductrices en contact électrique avec le rouleau tournant et une pièce électriquement conductrice en contact avec les fibres conductrices et reliées électriquement au pont de mesure.

Selon un mode de réalisation, le rouleau est un dévidoir d'un ruban conducteur.

Selon un mode de réalisation préféré, le rouleau tournant est un rouleau de mesure entraîné en rotation par le ruban conducteur qui défile tangentiellement au rouleau et de manière à être en contact avec celui-ci.

Le ruban conducteur peut être un film plastique métallisé ou bien un ruban métallique.

La pièce électriquement conductrice peut être en forme de U à l'intérieur duquel est serti un cavalier également en forme de U, les fibres conductrices étant retenues par coïncement entre la pièce électriquement conductrice et le cavalier, les fibres conductrices dépassant de manière à former au moins une rangée et de préférence deux rangées. Les fibres conductrices sont avantageusement des fibres de carbone.

L'invention sera mieux comprise à la lecture de la description ci-dessous, donnée à titre d'exemple non limitatif, en se reportant aux dessins ci-annexés où :

- les figures 1 et 2 représentent respectivement en vue latérale et en vue transversale un mode de réalisation de l'invention;

- la figure 3 représente en vue latérale un perfectionnement du mode de réalisation des figures 1 et 2;

- la figure 4 représente en vue latérale un autre mode de réalisation de l'invention.

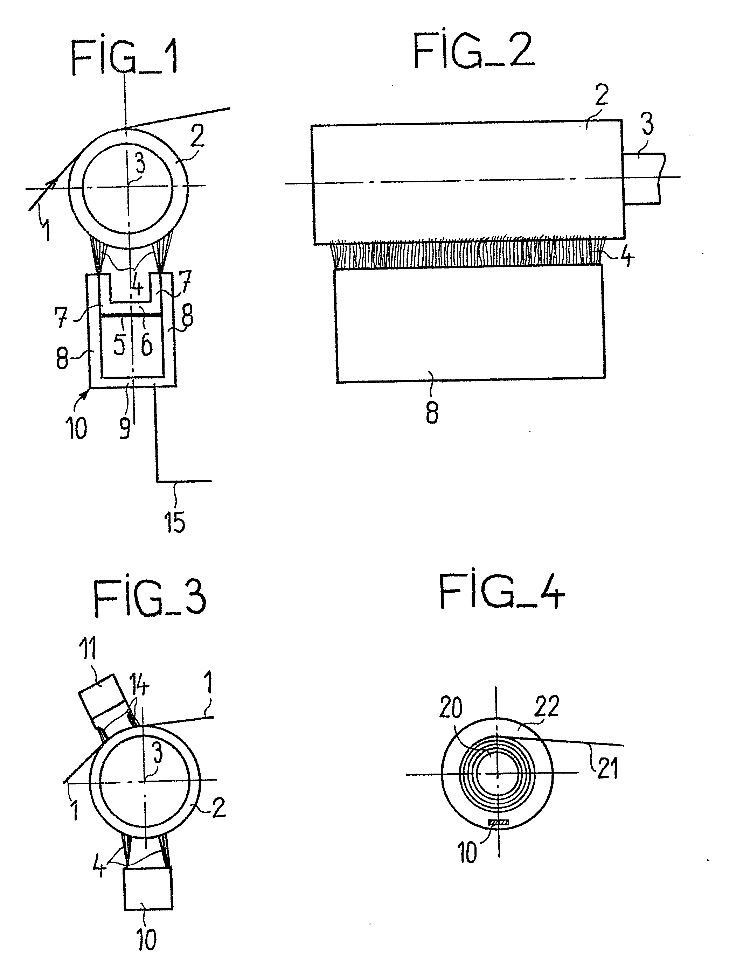

Selon la figure 1, un ruban conducteur, par exemple un film plastique métallisé ou un ruban métallique est déroulé à partir d'un dévidoir non représenté, et défile tangentiellement à un rouleau 2 monté librement autour de son axe 3 et est ensuite bobiné avec au moins un autre ruban conducteur de manière à réaliser un condensateur. Le rouleau 2 est un rouleau électriquement conducteur et se trouve en contact électrique avec le ruban conducteur 1. Ainsi, si celui-ci est un film plastique métallisé, il est disposé de manière telle que sa métallisation soit en contact avec le rouleau 2. A la face inférieure du rouleau 2, est disposée une brosse 10 comportant une pièce électriquement conductrice en forme de U comportant une partie centrale 9 et deux branches latérales 8, ainsi qu'un cavalier également en forme de U et comportant une partie centrale 6 et deux branches latérales 7. La largeur du cavalier 7 est légèrement inférieure à l'intervalle séparant les deux branches 8 du U constituant la pièce 10, de telle sorte que, les fibres conductrices 4 constituant la brosse soient maintenues par coïncement entre la pièce 10 et le cavalier en forme de U. Les fibres conductrices 4 dépassent de la pièce 10 et du cavalier de manière à former au moins une rangée de fibres en contact mécanique et électrique avec le rouleau 2. Au cas où la brosse comporte deux rangées de fibres conductrices, celles-ci sont constituées d'un seul faisceau bordant en 5 l'extérieur du cavalier en forme de U. On voit à la figure 2 l'ensemble des fibres conductrices 4 formant une brosse s'étendant sur toute la longueur du rouleau 2. On choisira par exemple pour les fibres conductrices des fibres de carbone. Etant donné le grand nombre de fibres conductrices mises en oeuvre, un bon contact électrique est obtenu sans que la force de pression sur le rouleau soit importante et d'autre part il n'y a pas de contact mécanique entre la brosse 4 et les parties conductrices du ruban conducteur 1.

Selon la variante de la figure 3, une seconde brosse 11 comportant des fibres conductrices ou non conductrices est disposée à la partie supérieure du rouleau 2 de manière à plaquer le ruban conducteur sur le rouleau de mesure 2. Dans le cas où le ruban conducteur 1 est un film plastique métallisé, on voit que les fibres 14 de la brosse 11 sont en contact avec le film plastique proprement dit, mais pas avec sa métallisation. Il en résulte que, dans ce mode de réalisation également, le film métallisé ne peut pas être détérioré.

Selon le mode de réalisation de la figure 4, le ruban conducteur, un film plastique métallisé ou de préférence un ruban métallique, est dévidé à partir d'un dévidoir 20 pourvu d'un flasque 22 en contact électrique avec le ruban conducteur. Si le ruban conducteur est un film plastique métallisé, il est en contact électrique avec le dévidoir 20, et le dévidoir 20 est en contact électrique avec le flasque 22. Si le ruban conducteur est un ruban métallique, il suffit que le flasque 22 se trouve en contact avec le ruban métallique 21. Le contact électrique avec le ruban conducteur 21 est obtenu grâce à une brosse 10 identique à celle décrite aux figures précédentes et dont les fibres conductrices 4 sont en contact électrique avec le flasque 22.

# R E V E N D I C A T I O N S

1. Dispositif de mesure de la capacité d'un condensateur au cours de son bobinage qui met en oeuvre l'enroulement de rubans superposés comportant au moins deux rubans conducteurs correspondant chacun à une électrode du conducteur et dans lequel chacun des rubans conducteurs est relié électriquement à un pont de mesure de capacité, caractérisé en ce qu'au moins un des rubans conducteurs (1) est mis en contact électrique avec un rouleau tournant (2, 20) électriquement conducteur et en ce qu'il comporte une brosse (10) présentant une pluralité de fibres conductrices (4) en contact électrique avec le rouleau tournant (2, 20), et une pièce électriquement conductrice (8, 9) en contact avec les fibres conductrices et reliée électriquement au pont de mesure.

2. Dispositif selon la revendication 1, caractérisé en ce que le rouleau tournant est un dévidoir (20) d'un ruban conducteur (21).

3. Dispositif selon la revendication 1, caractérisé en ce que le rouleau tournant est unn rouleau de mesure (2) entraîné en rotation par le ruban conducteur (1) qui défile tangentiellement au rouleau '2) et de manière à être en contact avec celui-ci.

4. Dispositif selon la revendication 3, caractérisé en ce qu'il comporte une deuxième brosse (11) plaquant le ruban conducteur (1) sur le rouleau de mesure (2).

5. Dispositif selon l'une des revendications 1 à 4, caractérisé en ce que le ruban conducteur est un film plastique métallisé.

6. Dispositif selon l'une des revendications 1 à 5, caractérisé en ce que le ruban conducteur est un ruban métallique.

7. Dispositif selon l'une des revendications précédentes, caractérisé en ce que la pièce électriquement conductrice (8, 9) est en forme de U à l'intérieur duquel est serti un cavalier (6, 7) en forme de U, les fibres conductrices (4) étant retenues par coïncement entre la pièce électriquement conductrice (8, 9) et le cavalier (6, 7), les fibres conductrices (4) dépassant de manière à former au moins une rangée.

5

8. Dispositif selon l'une des revendications précédentes, caractérisé en ce que les fibres conductrices sont arrangées suivant deux rangées.

9. Dispositif selon l'une des revendications précédentes, caractérisé en ce que les fibres conductrices sont des fibres de carbone.

0099788

1/1

FIG_1

FIG_2

FIG_3

FIG_4

0099788

Office européen
des brevets

**RAPPORT DE RECHERCHE EUROPEENNE**

Numéro de la demande

EP 83 40 1335

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| P,X | EP-A-0 060 739 (L.C.C.-C.I.C.E.) * Page 2, ligne 29 - page 4, ligne 7 * | 1 | H 01 G 13/02 |
| | --- | | |
| A | US-A-3 432 901 (W.J. FANNING) * Colonne 4, ligne 74 - colonne 5, ligne 46 * | | |
| | --- | | |
| A | FR-A-2 091 309 (BRITISH INSULATED CALLENDER'S CABLES LTD.) * Page 1, ligne 24 - page 3, ligne 35 * | | |
| | ----- | | |

| DOMAINES TECHNIQUES RECHERCHES (Int. Cl. 3) |
|---|
| H 01 G |

Le présent rapport de recherche a été établi pour toutes les revendications

| Lieu de la recherche LA HAYE | Date d'achèvement de la recherche 19-10-1983 | Examinateur SCHRIJVERS H.J. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03.82